# EUROPÄISCHE PATENTSCHRIFT

(11) **EP 0 862 354 B1**
(45) Veröffentlichungstag und Bekanntmachung des Hinweises auf die Patenterteilung: **14.08.2002**
(21) Anmeldenummer: 98102341.9
(22) Anmeldetag: 11.02.1998
(51) Int. Cl.: H05K 5/02

(54) **Vorrichtung zum Verschliessen von Druckausgleichsöffnungen**
Closing device for pressure equalising apertures
Dispositif pour fermer des ouvertures équilibrant la pression

(30) Priorität: 28.02.1997 DE 19708116
(43) Veröffentlichungstag der Anmeldung: 02.09.1998
(73) Patentinhaber: Conti Temic microelectronic GmbH, 90411 Nürnberg (DE)
(72) Erfinder: Baur, Richard, 85276 Pfaffenhofen (DE); Fendt, Günter, 86529 Schrobenhausen (DE)
(74) Vertreter: Maute, Hans-Jürgen, Dipl.-Ing.

(56) Entgegenhaltungen:
- EP-A- 0 039 869
- US-A- 4 639 818

## Beschreibung

Die Erfindung **betrifft** eine Vorrichtung zum Verschließen von Druckausgleichsöffnungen gemäß dem Oberbegriff des Patentanspruches 1.

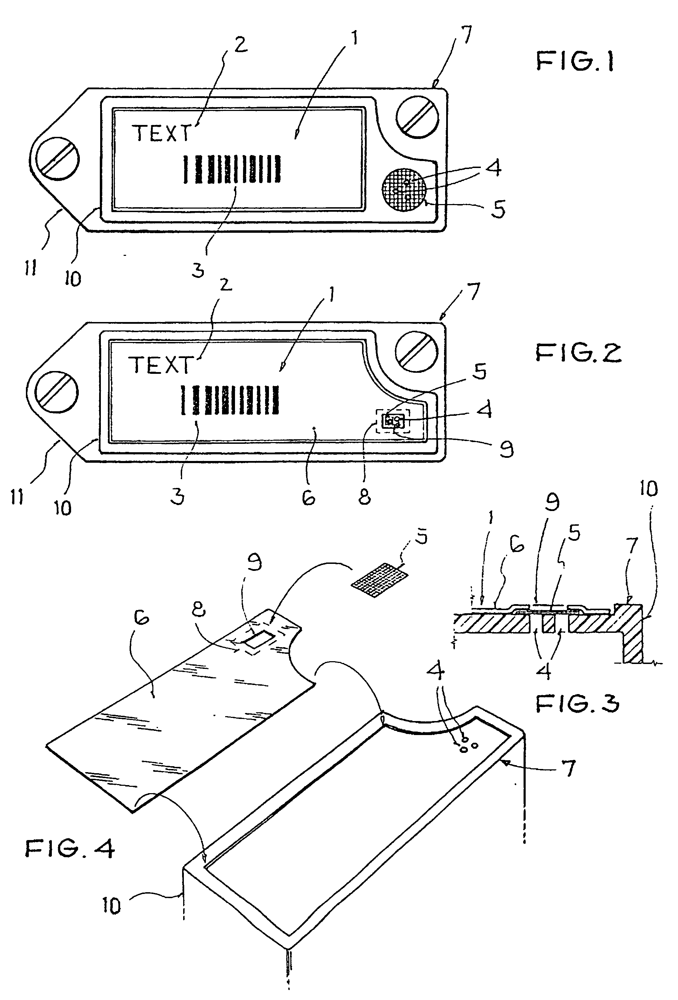

In der Regel werden elektronische Steuergeräte zum Schutz vor äußeren Einflüssen in ein Gehäuse eingebaut. Die Anforderungen an dieses Gehäuse sind beim Einsatz im Kraftfahrzeug besonders hoch. Einerseits muß das Gehäuse sogenannte Druckausgleichsöffnungen vorweisen, an denen ein Druckausgleich zwischen dem Gehäuseinnern und der Umgebung stattfinden kann. Zum anderen muß bei diesen Bauteilen das Gehäuse das Eindringen von Wasser verhindern, so daß die elektronische Schaltung vor Wasser- oder Feuchteschäden zuverlässig bewahrt wird. Dies wird zur Zeit dadurch realisiert, daß in das Gehäuse, welches in der Regel aus Metall oder einem festen Kunststoff besteht, kleine Löcher als Druckausgleichsöffnungen eingearbeitet werden, an denen eine Luftzirkulation stattfinden kann. Zum Schutz vor Wasser werden diese Löcher z.B. von Innen her mit einer atmungsaktiven und wasserdichten Folie, wie sie zum Beispiel unter dem Namen Goretex® oder Sympatex® bekannt ist, zugeklebt. Da diese wasserdichten und atmungsaktiven Folien sehr teuer sind, werden die Druckausgleichsöffnungen so kleinflächig wie möglichst abgedeckt. Deshalb werden auch die wasserdichten und atmungsaktiven Folien im Innern angebracht, so daß sie nicht unbeabsichtigt entfernt werden können. Dieser aktuelle Stand der Technik ist in **Figur 1** dargestellt.

Hierbei befindet sich das elektronische Steuergerät in dem dargestellten zweiteiligen Gehäuse **7**. Das eine Gehäuseteil **10** ist becherförmig und in der Regel aus Kunststoff, das andere Gehäuseteil **11** dient als Deckel bzw. Bodenverschluß. Diese Gehäuseteil ist aus Metall und weist Vorrichtungen zur Befestigung an das Kfz auf.

Auf dem angeschraubten Gehäuse **7**, insbesondere auf dem becherförmigen Gehäuseteil **10** befindet sich zum einen das aufgeklebte Etikett **1** mit der Beschriftung **2** und dem Barcode **3**. Daneben befinden sich sichtbar die Druckausgleichsöffnungen **4** die von innen her möglichst kleinflächig mit der wasserdichten, atmungsaktiven Folie **5** abgedichtet sind. Die Abbildung macht an dieser Stelle die ganze Folie sichtbar, die sich tatsächlich aber auf der Innenseite des Gehäuses, insbesondere im Innern des becherförmigen Gehäuseteils,**10** befindet

**Nachteilig** hierbei ist jedoch, daß für das Zukleben der Druckausgleichsöffnungen mit der wasserdichten und atmungsaktiven Folie ein zusätzlicher Arbeitsschritt benötigt wird. Ein weiterer Nachteil ergibt sich daraus, daß dieser Prozeßschritt nicht zuverlässig überwacht und überprüft werden kann.

Der Erfindung liegt daher die **Aufgabe** zugrunde eine Vorrichtung zum Verschließen von Druckausgleichsöffnungen der eingangs genannten Art zu schaffen, mit der die Druckausgleichsöffnungen wasserdicht und atmungsaktiv verschlossen werden, deren Anbringung keinen zusätzlichen Prozeßschritt benötigt und deren Montage überwacht und überprüft werden kann.

Die Aufgabe wird erfindungsgemäß durch die Merkmale im Kennzeichen des Patentanspruches 1 **gelöst**. Hierbei wird eine zweilagige Folie von vorne auf das Bauteil und über die Druckausgleichsöffnungen geklebt, wobei die zweite Lage durchgehend oder partiell ausgebildet ist und aus einem wasserdichten und atmungsaktiven Stoff besteht und die durchgehende erste Lage an den Stellen an denen der Druckausgleich erfolgt, entfernt ist und somit die Druckausgleichsöffnungen nur mit der zweiten Lage abgedeckt sind.

Die mit der Erfindung erzielten Vorteile sind das großflächige und günstige Umkleben der Druckausgleichsöffnungen von außen. Dadurch wird der Prozeßschritt, der das Verschließen der Druckausgleichsöffnungen beinhaltet, überwachbar.

Vorteilhafte Weiterbildungen der Erfindung ergeben sich aus den abhängigen Ansprüchen. Hierbei ist die erste Lage beschriftbar, so daß die erfindungsgemäße Vorrichtung als Typenschild oder Etikette verwendet werden kann und/oder auf ihr ein Barcode angebracht wird. Dadurch kann in einem Prozeßschritt das Typenschild oder eine ähnliche Vorrichtung angebracht und die Druckausgleichsöffnungen wasserdicht und atmungsaktiv verschlossen werden.

Ein **Ausführungsbeispiel** der Erfindung soll anhand den Figuren 2 bis 4 dargestellt werden.

Es zeigen:
- **Figur 1:**: Ausführungsbeispiel nach Stand der Technik
- **Figur 2:**: Draufsicht auf eine erfindungsgemäße Verschlußvorrichtung
- **Figur 3:**: Schnittdarstellung der erfindungsgemäßen Verschlußvorrichtung
- **Figur 4:**: Rückansicht der erfindungsgemäßen Verschlußvorrichtung

**Figur 2** zeigt die Draufsicht auf eine erfindungsgemäße Verschlußvorrichtung. In dem gezeigten Anwendungsfall handelt es sich bei der Verschlußvorrichtung um ein beschriftetes, mit einem Barcode **3** versehenen Etikett **1**, welches aus mehreren Lagen **5** und **6** besteht. Diese Etikett wird auf das Gehäuse **7** insbesondere auf den becherförmigen Gehäuseteil **10** aufgebracht.

Hier befinden sich auch die Druckausgleichsöffnungen **4**, die nur schematisch in der Darstellung sichtbar gemacht wurden aber eigentlich durch das Etikett **1** verdeckt sind. Die erste, oberste, sichtbare Schicht **6** dieses Etikettes **1** ist aus einem beschriftbaren Plastikmaterial, welches in der Regel luftundurchlässig und wasserdicht ist. Auf der Unterseite dieses Plastikmaterials **6** ist ein Klebstoff aufgetragen. Das Etikett **1** ist so groß, daß es die Druckausgleichsöffnungen **4** überdeckt, jedoch ist die oberste Schicht **6** an den Stellen entfernt, an denen ein Druckausgleich erfolgen soll. Dies ist durch die durchgezogene Linie **9** dargestellt. An diesen Stellen wird die zweite Schicht **5** sichtbar, die aus einem luftdurchlässigen, wasserdichten Stoff, wie z.B. Goretex® oder Sympatex® besteht. Unter dieser Lage **5** befinden sich die Druckausgleichsöffnungen **4**. Im Ausführungsbeispiel ist aus Kostengründen die zweite Lage **5** nur partiell auf die mit Kleber behaftete Unterseite der ersten Lage **6** angebracht. Dies ist durch die gestrichelte Linie **8** dargestellt. Diese nur partiell aufgebrachte zweite Lage **5** überdeckt möglichst kleinflächig die Druckausgleichsöffnungen **4** im Gehäuse **7**. Bei größeren Öffnungen **4** kann die zweite Lage **5** auch über die ganze Fläche der ersten Lage **6** angebracht werden und dann auf das entsprechende Gehäuseteil geklebt werden wobei die erste Lage **6** an den Stellen entfernt wird, an denen der Druckausgleich erfolgen soll. Bei mehreren Druckausgleichsöffnungen **4** kann jede einzelne Öffnung durch ein separates Teilstück abgedeckt werden. Als Alternative können auch alle Öffnungen durch ein zusammenhängendes Stück, wie in den Figuren dargestellt, verschlossen werden. Wichtig hierbei ist, daß eine genügend große Haftfläche zwischen der ersten **6** und der zweiten Lage **5** bestehen bleibt, so daß ein Verrutschen der zweiten Lage **5** ausgeschlossen werden kann oder die zweite Lage **5** direkt auf das Gehäuse **7** geklebt wird. Die erste Schicht **6** ist im Anwendungsbeispiel beschriftbar. Damit kann ein alphanumerischer Text **2**, wie die Typenbezeichnung oder das Herstellungsdatum und auch der Barcode **3** und andere relevante Daten auf die erste Lage **6** gedruckt werden, so daß die Verschließvorrichtung als Etikett **1** genutzt werden kann. Dieses im Vergleich zu den Druckausgleichsöffnungen **4** großflächige Etikett **1** läßt sich einfach, exakt und reproduzierbar immer auf die gleiche Stelle des Gehäuses **7** von oben, gut sichtbar aufkleben. In der Regel ist das bereits beschriftete, zweilagige Etikett **1** fertig zugeschnitten und die erste Lage bereits an den Stellen entfernt an denen später der Druckausgleich erfolgen soll. Zweckmäßig ist es die Kleberseite der ersten Lage **6** durch eine Abdeckung zu schützen, die erst unmittelbar vor dem Aufbringen des Etiketts **1** auf das Gehäuse **7** entfernt wird. Ein Versatz oder ein andere Fehler beim Aufbringen des Etiketts **1** auf das Gehäuseteil **7** kann sofort auch durch Maschinen z.B. optisch oder mechanisch oder bei einer Endkontrolle sehr einfach erkannt werden.

**Figur 3** zeigt eine Schnittdarstellung der erfindungsgemäßen Verschlußvorrichtung. Sie zeigt ein Gehäuse **7**, dessen Druckausgleichsöffnungen **4**, die sich im becherförmigen Gehäuseteil **10** befinden, mit der vorher beschriebenen zweilagigen Verschlußvorrichtung wasserdicht und atmungsaktiv verschlossen wird. Im Gehäuse **7** befinden sich die Druckausgleichsöffnungen **4**. Diese sind mit einer atmungsaktiven wasserundurchlässigen Membran **5**, der zweiten Lage, abgedeckt. Sie ist mit der ersten Lage **6** durch Klebstoff verbunden und aus Kostengründen möglichst kleinflächig und nur partiell über den Druckausgleichsöffnungen **4** angebracht. In dieser Abbildung wird deutlich, daß die zweite Lage **5** durch die erste Lage **6** mit dem Gehäuse **7** durch Kleben verbunden ist. Handelt es sich bei der ersten Lage **6** um eine luft- und wasserdichte Folie, so ist die Verbindung zwischen Gehäuse **7** und Membran **5** sogar hermetisch dicht. Dies bedeutet, daß die Luft aus den Gehäuseöffnungen **4** nur an den Stellen entweichen kann, an denen die erste Lage **6** entfernt wurde.

**Figur 4** zeigt eine Rückansicht der Verschlußvorrichtung. Hier sieht man die klebrige Unterseite der ersten Lage **6**, auf der im Bereich der gestrichelten Linie **8** die zweite Lage **5** aufgebracht ist und das Gehäuse **7**, insbesondere das becherförmige Gehäuseteil **10**, mit den Druckausgleichsöffnungen **4**. In der Darstellung sind die beiden Lagen **5**, **6** zur Verdeutlichung getrennt dargestellt. Sie sind aber bereits vor der Montage auf das Gehäuse **7** miteinander verklebt worden. Der kleine Bereich, der von der durchgezogenen Linie **9** begrenzt wird, zeigt an wo die erste Lage **6** entfernt wurde. An dieser Stelle ist der luftdurchlässige aber wasserdichte Membran **5** wirksam. Unter diesem Bereich befindet sich später eine oder mehrere Gehäuseöffnungen **4**, die durch die zweite Lage **5** geschützt werden. Auch kann sich bei einem derartigen Etikett zum Schutz vor Verschmutzung oder dem Klebstoff auf der Rückseite eine weitere Lage befinden, die vor dem Aufkleben des Etiketts **1** auf das Gehäuse **7** abgezogen wird.

Bei allen Abbildungen gilt jedoch, daß die Größe und Form der Aussparung **9** im Etikett **1** keinen Einfluß auf die Funktionsweise hat. Das bedeutet, daß bei runden Gehäuseöffnungen **4**, die Aussparung **9** im Etikett **1** wie dargestellt rechteckig sein kann, aber auch oval, rund, quadratisch oder alphanumerisch sein könnte.

Auch ist es für die Erfindung nicht relevant, ob das Aufbringen des Etiketts **1** auf das Gehäuse **7** durch einen Kleber, der bereits auf der Rückseite der ersten Lage **6** vorhanden ist, erfolgt oder durch einen separaten Kleber, der auch die zweite Lage **5** direkt mit dem Gehäuseteil **7** verbinden kann, bewerkstelligt wird.

Als Etiketten werden auch unbeschriftete, nicht mit einem Barcode versehene, weiße oder farbige Verschließvorrichtungen angesehen.

## Patentansprüche

1. Vorrichtung zum Verschließen von Druckausgleichsöffnungen (4) in Bauteilen, insbesondere eines Kfz-Steuergerätes, wobei diese Vorrichtung aus mindestens zwei Lagen (5, 6) aufgebaut ist, **dadurch gekennzeichnet, daß**
- die zweite durchgehende oder partielle Lage (5) aus einem wasserdichten und atmungsaktiven Stoff besteht und
- die erste Lage (6) an den Stellen, an denen der Druckausgleich erfolgt, entfernt ist und die Druckausgleichsöffnungen (4) nur mit der zweiten Lage (5) abgedeckt sind.

2. Vorrichtung zum Verschließen von Druckausgleichsöffnungen (4) nach Patentanspruch 1, **dadurch gekennzeichnet, daß** die erste Lage (6) beschriftbar ist.

3. Vorrichtung zum Verschließen von Druckausgleichsöffnungen (4) nach Patentanspruch 2, **dadurch gekennzeichnet, daß** die Vorrichtung als Typenschild oder Etikette (1) verwendet wird und die erste Lage (6) mit einem alphanumerischen Text (2) und/oder dem Barcode (3) versehen ist.

## Claims

1. Device for closing pressure equalising apertures (4) in components, in particular of a motor vehicle control instrument, wherein this device is composed of at least two layers (5, 6), **characterised in that**
- the second continuous or partial layer (5) consists of a watertight and breathable material and
- the first layer (6) is removed at the positions at which the pressure equalisation takes place, and the pressure equalising apertures (4) are only covered with the second layer (5).

2. Device for closing pressure equalising apertures (4) according to Claim 1, **characterised in that** the first layer (6) can be inscribed.

3. Device for closing pressure equalising apertures (4) according to Claim 2, **characterised in that** the device is used as an identification plate or label (1), and the first layer (6) is provided with an alphanumeric text (2) and/or the bar code (3).

## Revendications

1. Dispositif pour fermer des ouvertures d'équilibrage de pression (4) dans des composants, notamment d'un appareil de commande de véhicule automobile, ce dispositif étant constitué par au moins deux couches (5,6), **caractérisé en ce que**
- la deuxième couche continue ou partielle (5) est formée d'un matériau étanche à l'eau et actif du point de vue respiration, et
- la première couche (6) est éliminée aux emplacements, au niveau desquels l'équilibrage de pression s'effectue, et les ouvertures d'équilibrage de pression (4) sont recouvertes uniquement par la seconde couche (5).

2. Dispositif. pour fermer des ouvertures d'équilibrage de pression (4) selon la revendication 1, **caractérisé en ce qu'**une inscription peut être appliquée à la première couche (6).

3. Dispositif pour fermer des ouvertures d'équilibrage de pression (4) selon la revendication 2, **caractérisé en ce que** le dispositif est utilisé en tant que plaque signalétique ou étiquette (1) et que la première couche (6) est pourvue d'un texte alphanumérique (2) et/ou du code à barres (3).
